# EUROPEAN PATENT APPLICATION

(11) **EP 2 925 107 A1**
(43) Date of publication of application: **30.09.2015**
(21) Application number: 15020059.0
(22) Date of filing: 01.04.2010
(51) Int. Cl.: H05K 7/20, F28D 15/02

(54) **A cooling unit**

(30) Priority: 03.04.2009 GB 0905870
(62) Divisional of application: 10719760.0
(71) Applicant: EATON-WILLIAMS GROUP LIMITED, Edenbridge, Kent TN8 6EG (GB)
(72) Inventor: Muir, Jeff, Hastings, TN34 2EZ (GB); Didymiotis, Dion, London, SW19 2DW (GB)
(74) Representative: Crouch, David John

(57) **Abstract**

A cooling unit comprising a first passageway through which coolant fluid is passed when the unit is in use, and a second passageway through which coolant fluid is passed when the unit is in use, portions of the first and second passageways being thermally coupled to one another so as to constitute a heat exchanger of the unit. The coolant fluid which passes through the said second passageway when the unit is in use is passed to at least one heat exchanger in a space which is to be cooled. Coolant fluid in the said second passageway is at least partially gaseous when the unit is in use. The heat exchanger of the unit is constituted by a condenser. The unit further comprises at least one pressure sensor connected to monitor the pressure in the said second passageway and a parameter adjuster connected to enable adjustment of a parameter of coolant fluid in the said first passageway. The coolant fluid in the said at least one heat exchanger is in a bi-phase state when the unit is in use. The unit further comprising a processor connected to receive signals from the said at least one pressure sensor, and to issue signals to the parameter adjuster to adjust a parameter of coolant fluid in the said first passageway. This changes the pressure in the said second passageway when the unit is in use, thereby to control the temperature of the coolant in the said at least one heat exchanger.

Also, a method of cooling a space comprising passing coolant fluid through a first passageway, and passing a coolant through a second passageway, portions of the first and second passageways being thermally coupled to one another so as to constitute a heat exchanger. The coolant fluid which passes through the said second passageway is passed to at least one heat exchanger in the space which is to be cooled. Coolant fluid in the said second passageway is at least partially gaseous and the heat exchanger constituted by portions of the said first and second passageways constitutes a condenser, the coolant fluid in the said at least one heat exchanger is in a bi-phase state. A parameter of the coolant fluid in the said first passageway is changed to change the pressure of the coolant fluid in the said second passageway, thereby to control the temperature of the coolant in the said at least one heat exchanger.

## Description

Data centres are cooled by perimeter cooling, in which air to liquid heat exchangers are situated around the outside of the room and air is pumped from the interior of the data centre, down through the air to liquid heat exchangers, underneath the floor of the data centre, and from there upwards through air vents in the flooring into aisles between rows of blade racks. The cool air in these aisles passes by convection between the blades and out through to the other side of the row of racks, into a warm aisle. The warm air in the warm aisles passes by convection to the air above the racks, along the ceiling and then downwards once again through the air to liquid heat exchangers of the perimeter cooling. This cycle is continuous to keep the temperature of the centre at an acceptably low level for efficient operation of the blades.

With increasing operational capacity of the blades, an increasing amount of cooling of the air in the data centre becomes desirable or even necessary. Simply increasing the cooling capacity of the perimeter cooling is not necessarily an option because of limitation in the amount of cooling that can be effected in this way. This problem has been solved by attaching air to water heat exchangers at the rear of the racks, where the air flow exits from the racks. Such heat exchangers are referred to as rear door heat exchangers. They use water as the cooling medium because water has a relatively high specific heat compared to other coolants. The temperature of the water supplied to the rear door heat exchangers is about what would be considered normal room temperature or only slightly lower, typically in the region 18°C to 22°C. This is still effective because the air temperature where it exits the blades is higher, perhaps in the region of from 35°C to 45°C.

The use of water so close to electronic equipment may constitute a risk of short circuiting and damage to the equipment. This poses a problem because no other safe cooling medium has sufficient specific heat.

The present invention seeks to provide a remedy.

Accordingly, the present invention is directed to a cooling unit comprising a first passageway through which coolant fluid is passed when the unit is in use, and a second passageway through which coolant fluid is passed when the unit is in use, portions of the first and second passageways being thermally coupled to one another so as to constitute a heat exchanger of the unit, the coolant fluid which passes through the said second passageway when the unit is in use being passed to at least one heat exchanger in a space which is to be cooled, in which coolant fluid in the said second passageway is at least partially gaseous when the unit is in use and the heat exchanger of the unit is constituted by a condenser, and in which the unit further comprises at least one pressure sensor connected to monitor the pressure in the said second passageway and a parameter adjuster connected to enable adjustment of a parameter of coolant fluid in the said first passageway, the coolant fluid in the said at least one heat exchanger being in a bi-phase state when the unit is in use, the unit further comprising a processor connected to receive signals from the said at least one pressure sensor, and to issue signals to the parameter adjuster to adjust a parameter of coolant fluid in the said first passageway so as to change the pressure in the said second passageway when the unit is in use, thereby to control the temperature of the coolant in the said at least one heat exchanger.

The pressure in a downstream header of the said at least one heat exchanger is especially pertinent to this end. The unit may further comprise a temperature and humidity sensor or sensors located in the space to be cooled when the unit is in use, which temperature and humidity sensor or sensors are connected to the said processor, and in which the processor is such as to issue signals to the parameter adjuster in such a fashion as to maintain the temperature of the coolant fluid in the said at least one heat exchanger above the dew point of the air in the space being cooled as indicated by the temperature and humidity sensor or sensors.

The said parameter may be the flow of coolant through the said second passageway, the parameter adjuster being a variable control valve or a variable pump.

The unit may further comprise a separator connected in the said second passageway to separate gas from liquid of the coolant in that passageway.

The separator may be connected to deliver the gaseous part of the coolant to the condenser, and the liquid part of that coolant to a part of the said second passageway which by-passes the condenser.

The unit may further comprise a reservoir connected to the said second passageway to hold a reserve amount of liquid of the coolant in the said second passageway.

The reservoir may be connected to that part of the said second passageway which bypasses the condenser.

The invention extends to cooling apparatus comprising such a cooling unit as set out in the preceding paragraphs connected to such a said at least one heat exchanger so that the coolant of the said second passageway passes through the said at least one heat exchanger.

The said at least one heat exchanger may be a bi-phase coolant rear door heat exchanger.

Because the effective coolant in such an exchanger is bi-phase, that is to say part gaseous and part liquid, the latent heat of the transition between the liquid and gaseous states of the coolant is used to compensate for the relatively low specific heat of the coolant in its liquid state.

Preferably the bi-phase rear door heat exchanger has a multiplicity of coolant conducting loops each connected at one end to a common inlet or upstream header and at its other end to a common outlet or downstream header. This provides balanced cooling over the whole extent of the door.

Preferably the headers are elongate and cylindrical, the diameter of the outlet header being larger than that of the inlet header to accommodate the creation of a bi-phase coolant at the connections between the loops and the common inlet header. More preferably, the ratio of the outlet header internal diameter to the inlet header internal diameter is in the range from 1.1 to 1.5, for example about 1.3 which is especially suitable if the coolant is R134a refrigerant (1,1,1,2-tetrafluoroethane).

Preferably respective orifices are provided at the ends of the loops which are connected to the inlet header.

This may be used to ensure that coolant in the loops is bi-phase.

Advantageously, the loops extend generally horizontally. This matches a horizontal orientation of the blades.

The headers preferably extend generally vertically, and if the door is hinged at one side to a generally vertical hinge, the headers are preferably on the hinge side of the door to reduce the amount of movement thereof when the door is opened and closed. This facilitates connection of the headers to a coolant circuit.

Advantageously the headers are provided at respective ends with respective quick release connectors, for example bayonet connectors.

Thus, air exiting a blade rack may be cooled by means of a heat exchanger through which bi-phase coolant is passed and which may be as set out in one or more of the preceding paragraphs.

Advantageously, the coolant is one which has a boiling point close to normal room temperature, for example in the range from 15°C to 25°C. This facilitates the bi-phase construction. For example the coolant may comprise R134a refrigerant (1,1,1,2-tetrafluoroethane).

The present invention extends to a method of cooling a space comprising passing coolant fluid through a first passageway, and passing a coolant through a second passageway, portions of the first and second passageways being thermally coupled to one another so as to constitute a heat exchanger, the coolant fluid which passes through the said second passageway being passed to at least one heat exchanger in the space which is to be cooled, in which coolant fluid in the said second passageway is at least partially gaseous and the heat exchanger constituted by portions of the said first and second passageways constitutes a condenser, the coolant fluid in the said at least one heat exchanger being in a bi-phase state, and in which a parameter of the coolant fluid in the said first passageway is changed to change the pressure of the coolant fluid in the said second passageway, thereby to control the temperature of the coolant in the said at least one heat exchanger.

The coolant in the said second passageway may comprise R134a refrigerant (1,1,1,2-tetrafluoroethane).

An example of a cooling unit made in accordance with the present invention will now be described in greater detail with reference to the accompanying drawings, in which:
- Figure 1: shows a perspective view from one side and from above of a data centre incorporating rear door heat exchangers, to which is connected a cooling unit embodying the present invention;
- Figure 2: shows a rear elevational view of one of the rear door heat exchangers shown in Figure 1;
- Figure 3: shows a view from above of the rear door heat exchanger shown in Figure 2;
- Figure 4: shows a side view of the rear door heat exchanger shown in Figures 2 and 3;
- Figure 5: shows a view from the other side of the rear door heat exchanger shown in Figures 2 and 3;
- Figure 6: shows a view of the same side of the door as is shown in Figure 5 but with parts thereof removed to reveal other parts of the exchanger;
- Figure 7: shows an axial sectional view of parts of the rear door heat exchanger shown in Figures 1 to 6;
- Figure 8: is an electrical and fluid circuit diagram of apparatus embodying the present invention;
- Figure 9: shows a diagrammatic axial sectional view through a separator of the apparatus shown in Figure 8;
- Figure 10: shows the cross-section through a coil of the apparatus shown in Figure 8 when the latter is in use; and
- Figure 11: shows an explanatory graph.

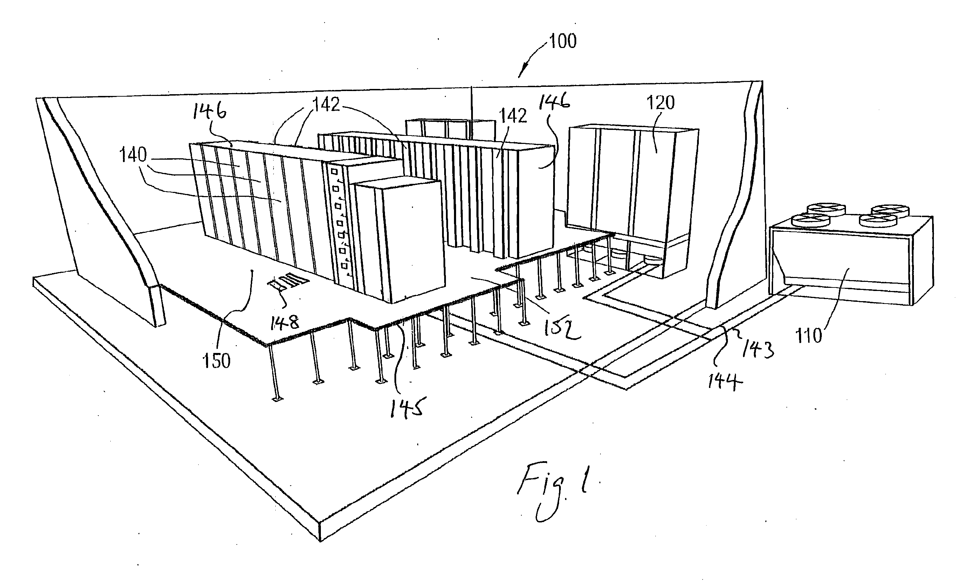

Figure 1 shows a data centre 100 provided with a chiller unit 110 connected to supply cooling water to perimeter cooling 120. The data centre 100 is provided with rows of blade racks 140, the blade racks 140 being provided with respective rear door heat exchangers 142. Chilled water from the chiller 110 is pumped through feed piping 143 to the perimeter cooling 120 and warm water returns from the perimeter cooling 120 to the chiller 110 through further piping 144.

The perimeter cooling 120, and the blade racks 140 with their rear door heat exchangers 142 rest on a raised floor 145. The blade racks 140 are arranged in rows 146. Air vents 148 are provided in the raised floor 145 in one or more aisles 150 between rows 146, with adjacent aisles 152 being without vents, so that aisles with vents alternate with those without. When the data centre 100 is in use, warm air in a warm aisle 152 rises upwardly and draws with it through the racks 140 cool air from the adjacent cool aisles 150. This creates a continual draft of cool air through the racks 140. The warm air rises towards the ceiling of the data centre and outwardly towards the perimeter cooling 120 where it is cooled and therefore falls downwardly to exit the perimeter cooling 120 underneath the raised flooring 145. This convection current continues with the cool air rising upwardly through the vents 148 to continue the air cooling cycle.

The rear door heat exchangers 142 provide additional cooling of the air flowing through the data centre 100, the cooling medium flowing through them being provided by a cooling unit 153.

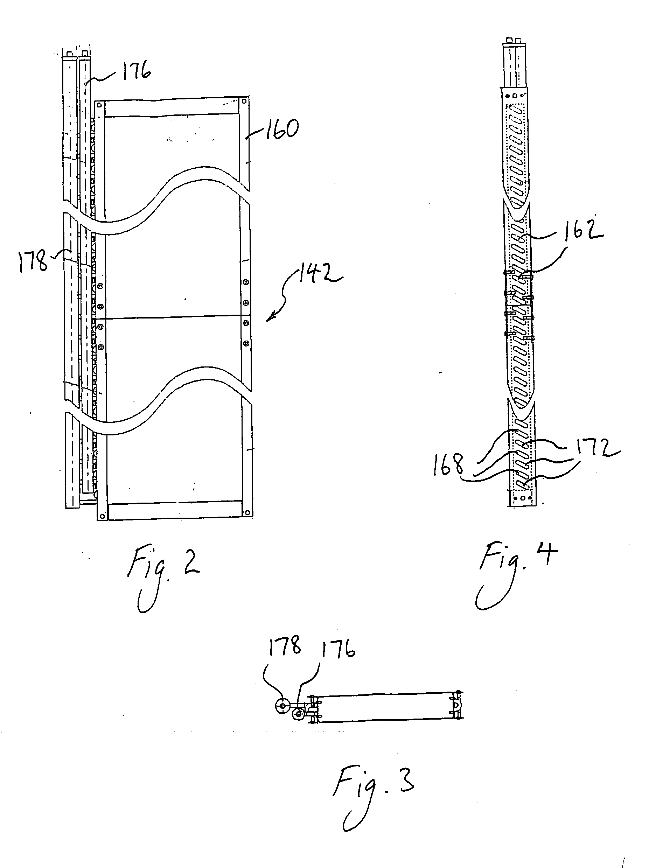

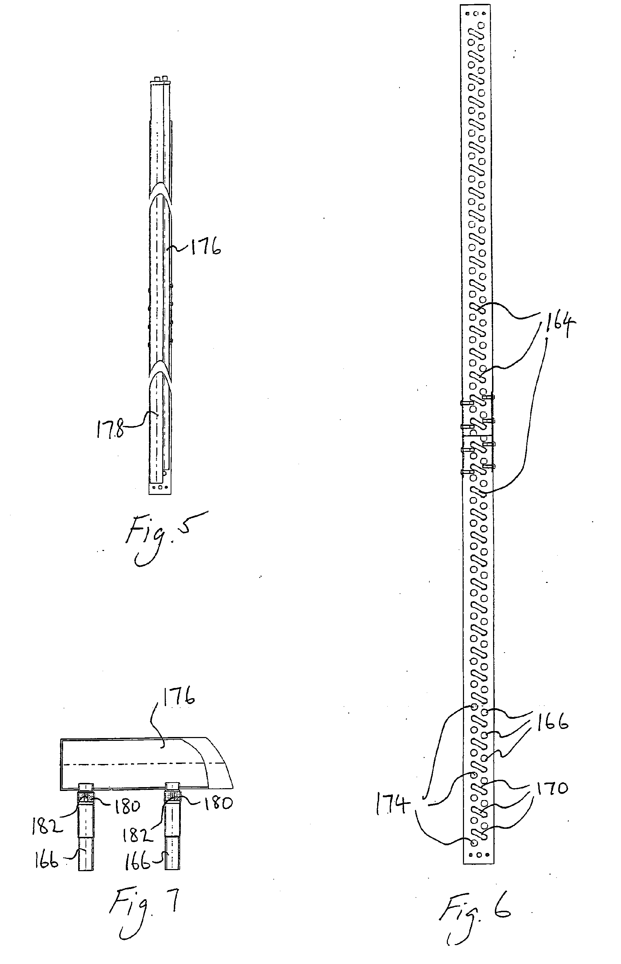

The construction of each rear door heat exchanger 142 is shown in greater detail in Figures 2 to 6. From these Figures it will be seen that the rear door heat exchanger 142 comprises a frame 160 supporting metal tubing 162. This tubing comprises a multiplicity of horizontally extending loops or coils 164. Each coil comprises an inlet 166 on one side of the frame 160 to a straight horizontal section of the loop or coil which extends through to the opposite side of the frame 160 where it bends on a slant through a 180° curve 168. From there it extends straight and horizontally back to the first side of the door where it passes through another slanting 180° bend 170 into a further straight horizontal section of the loop or coil to the other side of the door where it extends through a third slanting 180° bend 172 into a fourth straight horizontal section of the coil to the first side of the door, in which is located the inlet 166, to an outlet 174.

Each inlet 166 is in fluid communication with a generally vertically arranged cylindrical inlet header 176.

Each loop or coil outlet 174 is connected to a common vertically arranged cylindrical outlet header 178.

The ratio of the internal diameter of the outlet header to that of the inlet header is substantially 1.3. In the illustrated exchanger, the internal diameter of the outlet header is 35mm, and that of the inlet header is 28mm, giving a ratio of 1.25.

The connection from the inlet header 176 to the coil inlets 166 is via respective nozzles 180. Each nozzle 180 comprises an orifice 182 having a diameter appropriate for receiving coolant as a liquid and changing it to a liquid/gas bi-phase coolant. By comparison, the connection between each coil outlet 174 and the outlet header 178 does not have such a nozzle 180 so that the full width of the coil pipe is available for transfer of fluid to the outlet header 178, appropriate for the coolant being in a gaseous or a vaporized bi-phase state. In this fashion, the rear door heat exchanger illustrated in Figures 2 to 7 is constructed as a bi-phase coolant rear door heat exchanger.

The door is connected to an associated blade rack 140 by way of hinges (not shown) located on the same side of the door 142 as the inlet and outlet headers 176 and 178. This enables the rear door heat exchanger to be opened to provide access to the rear of the blade rack. When the rear door heat exchanger 142 is installed as shown in Figure 1, the inlet and outlet headers 176 and 178 are connected to a refrigerant unit by way of flexible tubing (not shown) which unit pumps cooled liquid coolant to the inlet header 176 and receives gaseous and/or vaporized coolant from the outlet header 178. The presence of the inlet and outlet headers 176 and 178 on the hinged side of the rear door heat exchanger 142 reduces the travel of the flexible tube connectors (not shown) to those headers when the rear door heat exchanger is opened or closed.

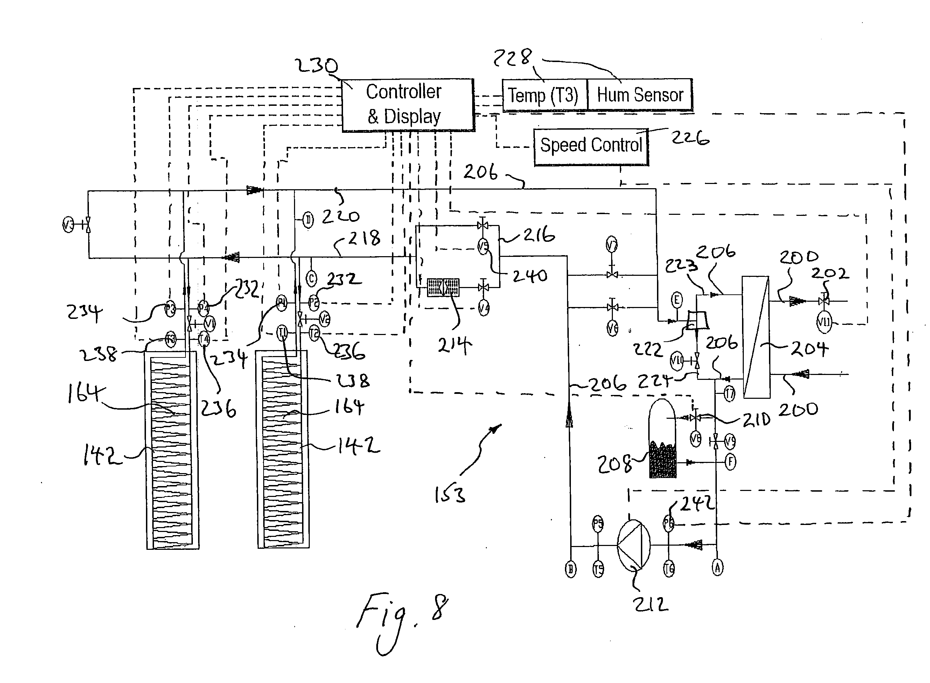

In the apparatus shown in Figure 8, the bi-phase rear door heat exchangers 142 shown in Figures 1 to 6 are also shown labeled 142. In addition, the cooling unit comprising the other parts of the apparatus shown in Figure 8 is labelled generally by the reference numeral 153. The latter comprises a first passageway 200 through which cooling water is passed when the apparatus is in use. A variable control valve 202 is connected in the passageway 200 to enable the flow of cooling water therethrough to be varied. Part of the passageway 200 is constituted by a part of a condenser 204. Another part of that condenser in thermal communication with the first-mentioned part thereof is a second passageway 206 through which flows refrigerant R134a (1,1,1,2-tetrafluoroethane).

Following the passageway 206 in a downstream direction from the condenser 204, there is provided a coolant reservoir 208 connected in parallel to that passageway. An input from the passageway 206 to the reservoir 208 is provided with a control valve 210.

Progressing further downstream along the passageway 206, there is provided a pump 212 provided to pump coolant around the said second passageway 206.

Further downstream of the passageway 206 there is provided a filter 214 connected in parallel with a part 216 of the passageway 206 which is in parallel with the filter 204 and bypasses the latter. Downstream from the filter 214 there is provided an input line 218 of the passageway 206 and output line 220 thereof.

Each bi-phase rear door heat exchanger 142 has an input connected to the input line 218 and an output connected to the output line 220 so that coolant in the passageway 206 passes through the coils 164 of the rear door heat exchangers 142 via their respective headers. Continuing downstream along the passageway 206 from the output line 220 thereof, the passageway connects to a separator 222 having a first branch line 223 which connects to the condenser 204 and a second branch line 224 which is in parallel with and bypasses the condenser 204.

A pump speed control 226 is electrically connected to control the pump 212. The cooling unit 153 is also provided with a temperature and humidity sensor or sensors 228 located within the data centre 100 to provide a measure of the temperature and humidity of the air in the data centre 100.

The unit 153 is also provided with a controller and display 230. The latter is connected to receive signals from respective pressure meters 232 connected to measure the pressure of coolant fluid in the inlets to the heat exchangers 142, from respective pressure meters 234 connected to measure the pressure of coolant in the outlets of the heat exchangers 142, from respective thermometers or temperature sensors 236 positioned to measure the temperature of coolant in the inlets to the heat exchangers 142, from respective thermometers or temperature sensors 238 to measure the temperature of coolant in the outlets of the heat exchangers 142, and also from the temperature and humidity sensor or sensors 228.

The controller and display 230 is also connected to control a variable valve 240 connected to control the flow of coolant through the part 216 of the second passageway 206. The controller and display 230 is also connected to control the variable control valve 210, the pump 212 and the variable control valve 202.

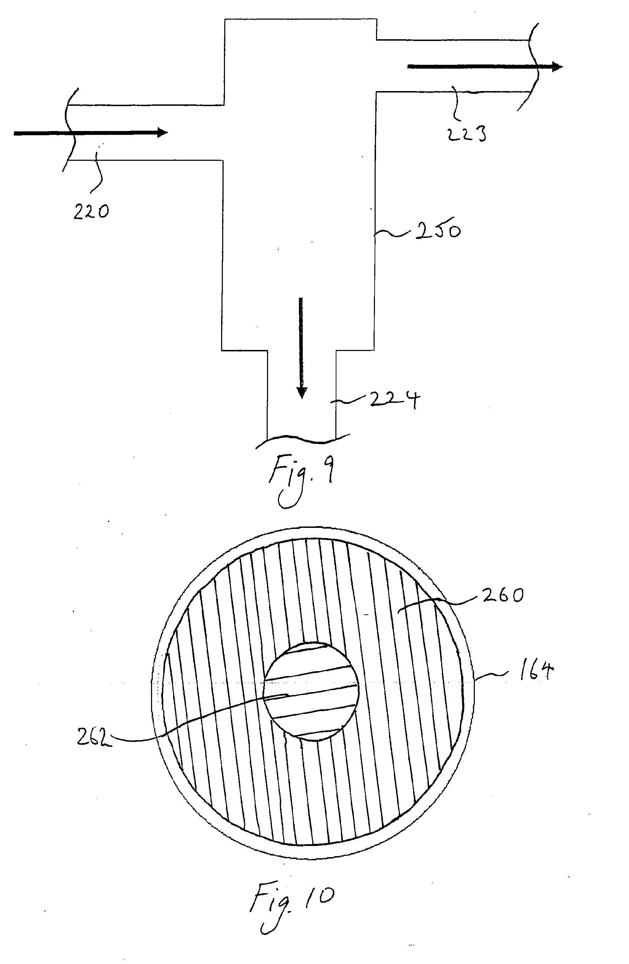

Further details of the separator are shown in Figure 9. Thus, it comprises a generally upright cylindrical chamber 250 having an internal cross-sectional area substantially greater than the internal cross-sectional areas of the passageways 220, 223 and 224. The passageway 224 extends downwardly from the lower end of the cylindrical chamber 250, the part 220 of the passageway 206 enters into an upper half of the cylindrical chamber 250, and the part 223 of the passageway 206 constitutes an outlet from the cylindrical chamber 250 at a position above the position at which the part 220 of the passageway 206 enters the cylindrical chamber 250.

The control unit 153 operate as follows.

With cooling water flowing through the first passageway 200, liquid coolant flows through the passageway 206 to the pump 212 which urges the fluid further along the passageway 206, either through the filter 214 or along the filter bypass 216 to the inlet line 218. From here coolant flows into the coils 164 of the rear door heat exchangers 142. The nozzles 180 thereof and the pressure of the coolant in the second passageway 206 are such as to cause a pressure drop across the nozzles 180 as to result in the coolant within the coils 164 of the rear door heat exchanger 142 being in a bi-phase state, partially liquid and partially gas.

Figure 10 shows a cross-section through a coil 164 which shows the coolant in contact with the inner surface of the coil 164 in liquid state 260 and in a central region of the coil 164 in a gaseous state 262. This bi-phase coolant is returned to the outlet line 220 at a pressure of about 5.2 bars ± 10%. The latter passes the coolant in the bi-phase state to the separator 222. Here the heavier liquid part of the coolant falls into the lower half of the cylindrical chamber 250 and the lighter gaseous part of the coolant rises into the uppermost part of the cylindrical chamber 250. The gaseous part of the coolant proceeds along that part 223 of the passageway 206 of the condenser 204 where it is condensed into liquid form so that it passes through an outlet of the condenser 204 where it joins the liquid part of the coolant which has descended through the part 224 of the passageway 206, before it returns to the pump 212. Thus, the cycle continues.

The controller and display 230 controls the speed control 226 which in turn controls the pump 212 to operate within a predetermined range of pump speeds. At the same time, in the event that the pressure sensor 242 issues signals to the controller and display 230 below a predetermined value, such as creates a risk of cavitation within the pump 212, the controller and display 230 is programmed to issue a signal to the speed control 226 to lower the speed of the pump 212.

In the event that the signals issued by the temperature and humidity sensor or sensors 228 and the temperature sensors 236 and 238 indicate that the temperature of the coolant within the coils 164 is unacceptably close to the dew point of the air in the date centre 100, the controller and display issues a signal to the valve 202 in the said first passageway 200 to reduce the available cross-sectional area through the valve 202 so as to reduce the flow rate of cooling water 200 through the condenser 204 so as to increase the pressure and the temperature of the coolant fluid in the said second passageway 206.

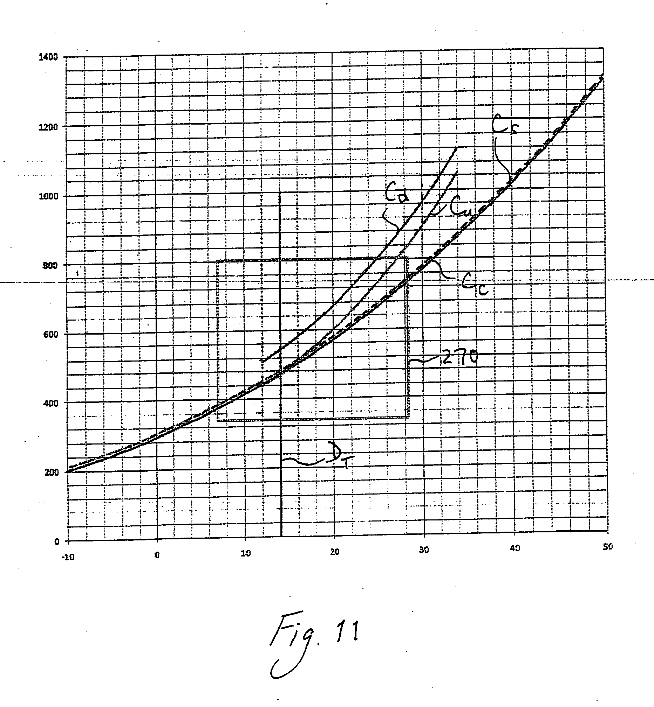

Figure 11 shows a representation of the relationships between different variables in the apparatus of Figure 8 and the data centre shown in Figure 1. In this graph, temperature in degrees centigrade is indicated along the horizontal axis and pressure in KPa is indicated along the vertical axis. Thus, the dew point within the centre 100 is represented by a vertical line D_{T} in Figure 11. The curve C_{c} shows the saturation curve of the coolant in the said second passageway, the dotted curve Cₛ shows the same curve with a safety margin factor built in to reduce the likelihood of condensation. The curve Cᵤ represents variation of system pressure as a function of the temperature of coolant immediately upstream of the pump 212, that is to say, on the suction side thereof, and C_{d} is the same curve for the downstream or higher pressure side thereof.

It can be seen therefore that the working region of the pump 212 must remain within the upper right-hand portion of the box 270.

## Claims

1. A cooling unit comprising a first passageway through which coolant fluid is passed when the unit is in use, and a second passageway through which coolant fluid is passed when the unit is in use, portions of the first and second passageways being thermally coupled to one another so as to constitute a heat exchanger of the unit, the coolant fluid which passes through the said second passageway when the unit is in use being passed to at least one heat exchanger in a space which is to be cooled, in which coolant fluid in the said second passageway is at least partially gaseous when the unit is in use and the heat exchanger of the unit is constituted by a condenser, and in which the unit further comprises at least one pressure sensor connected to monitor the pressure in the said second passageway and a parameter adjuster connected to enable adjustment of a parameter of coolant fluid in the said first passageway, the coolant fluid in the said at least one heat exchanger being in a bi-phase state when the unit is in use, the unit further comprising a processor connected to receive signals from the said at least one pressure sensor, and to issue signals to the parameter adjuster to adjust a parameter of coolant fluid in the said first passageway so as to change the pressure in the said second passageway when the unit is in use, thereby to control the temperature of the coolant in the said at least one heat exchanger.

2. A cooling unit according to claim 1, **characterised in that** the unit further comprises a temperature and humidity sensor or sensors located in the space to be cooled when the unit is in use, which temperature and humidity sensor or sensors are connected to the said processor, and **in that** the processor is such as to issue signals to the parameter adjuster in such a fashion as to maintain the temperature of the coolant fluid in the said at least one heat exchanger above the dew point of the air in the space being cooled as indicated by the temperature and humidity sensor or sensors.

3. A cooling unit according to claim 1 or claim 2, **characterised in that** the said parameter is the flow of coolant through the said second passageway, the said parameter adjuster being a variable control valve or a variable pump.

4. A cooling unit according to any preceding claim, **characterised in that** the unit further comprises a separator connected in the said second passageway to separate gas from liquid of the coolant **in that** passageway.

5. A cooling unit according to claim 4, **characterised in that** the separator is connected to deliver the gaseous part of the coolant to the condenser, and the liquid part of that coolant to a part of the said second passageway which by-passes the condenser.

6. A cooling unit according to any preceding claim, **characterised in that** the unit further comprises a reservoir connected to the said second passageway to hold a reserve amount of liquid of the coolant in the said second passageway.

7. A cooling unit according to claim 6, **characterised in that** the reservoir is connected to that part of the said second passageway which bypasses the condenser.

8. Cooling apparatus comprising a cooling unit as claimed in any preceding claim, connected to such a said at least one heat exchanger so that the coolant of the said second passageway passes through the said at least one heat exchanger.

9. Cooling apparatus according to claim 8, **characterised in that** the said at least one heat exchanger is a bi-phase coolant rear door heat exchanger.

10. A method of cooling a space comprising passing coolant fluid through a first passageway, and passing a coolant through a second passageway, portions of the first and second passageways being thermally coupled to one another so as to constitute a heat exchanger, the coolant fluid which passes through the said second passageway being passed to at least one heat exchanger in the space which is to be cooled, **characterised in that** coolant fluid in the said second passageway is at least partially gaseous and the heat exchanger constituted by portions of the said first and second passageways constitutes a condenser, the coolant fluid in the said at least one heat exchanger being in a bi-phase state, and **in that** a parameter of the coolant fluid in the said first passageway is changed to change the pressure of the coolant fluid in the said second passageway, thereby to control the temperature of the coolant in the said at least one heat exchanger.

11. A method of cooling a space according to claim 10, **characterised in that** the coolant in the said second passageway comprises R134a refrigerant (1,1,1,2-tetrafluoroethane).

12. A method of cooling a space according to claim 10 or claim 11, **characterised in that** the method is carried out using a cooling unit or apparatus as claimed in any one of claims 1 to 9.
